# FASCICULE DE BREVET EUROPEEN

(11) **EP 0 762 428 B1**
(45) Date de publication et mention de la délivrance du brevet: **11.11.1998**
(21) Numéro de dépôt: 96460031.6
(22) Date de dépôt: 02.09.1996
(51) Int. Cl.: G11C 16/06

(54) **Procédé et circuit de programmation et d'effacement d'une mémoire**
Verfahren und Schaltkreis zum Programmieren und Löschen eines Speichers
Method and circuit for programming and erasing a memory

(30) Priorité: 05.09.1995 FR 9510577
(43) Date de publication de la demande: 12.03.1997
(73) Titulaire: SGS-THOMSON MICROELECTRONICS S.A., 94250 Gentilly (FR)
(72) Inventeur: Naura, David, 56100 Lorient (FR); Devin, Jean, 56100 Lorient (FR)
(74) Mandataire: Schmit, Christian Norbert Marie

(56) Documents cités:
- EP-A- 0 621 603
- US-A- 4 996 571

## Description

L'invention concerne un procédé de programmation et d'effacement d'une cellule mémoire réalisée à partir de transistors à grille flottante et le circuit s'y rapportant. Elle s'applique tout particulièrement aux mémoires non volatiles, programmables et effaçables électriquement (EEPROM, flash EPROM).

Les cellules mémoire de ces mémoires font appel à une technologie utilisant des transistors à grille flottante. Pour la programmation ou l'effacement d'une telle cellule mémoire, il est nécessaire de produire des hautes tensions de l'ordre de 15 à 20 volts.

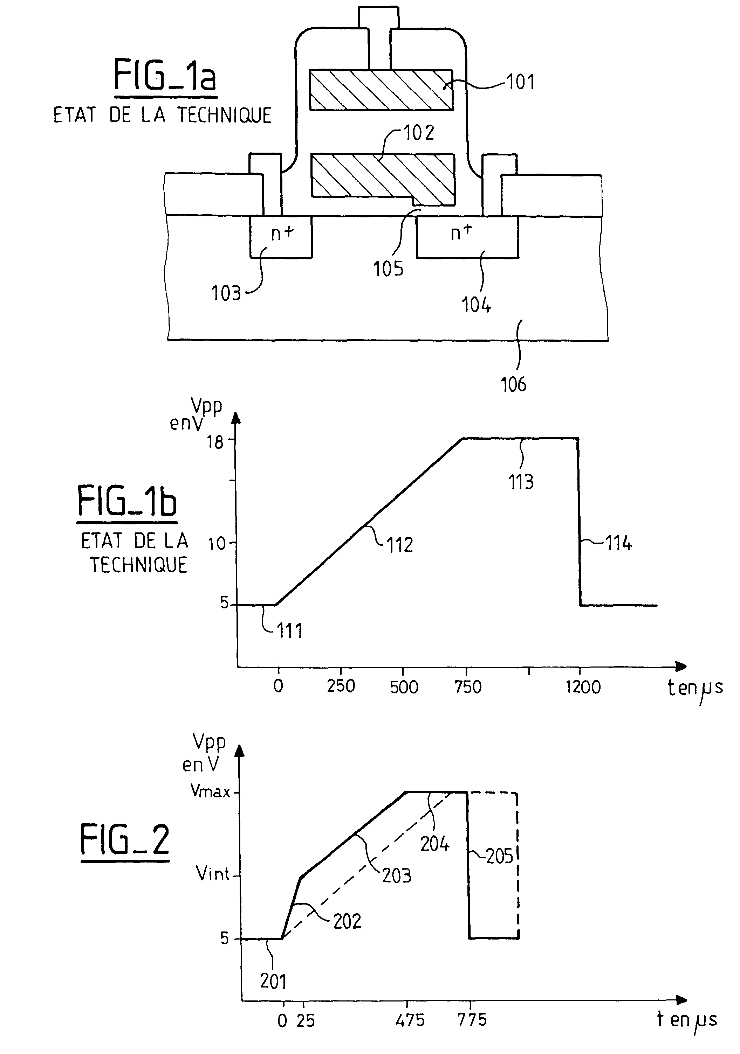

Une cellule mémoire d'une mémoire EEPROM est constituée d'un transistor à grille flottante (figure la) comportant une grille de commande 101, une grille flottante 102, une région source 103, une région drain 104, une couche d'oxyde 105 et une région substrat 106. La grille 102 est dite flottante car elle ne posséde aucun contact avec l'extérieur lui imposant un potentiel. La grille de commande 101 est reliée à une ligne de mot de la mémoire et la région drain 104 à une ligne de bit de la mémoire. La structure représentée à la figure 1a montre que l'épaisseur d'oxyde 105 entre la grille flottante 102 et la région substrat 106 est très réduite. Typiquement, elle est de l'ordre de quelques nanomètres. La faible épaisseur d'oxyde permet à cet endroit le passage d'électrons par effet tunnel.

Pour programmer une cellule mémoire, on applique à la ligne de mot, reliée à la grille de commande 101 de la cellule mémoire, une tension fortement positive et à la ligne de bit, reliée à la région drain 104, une tension nulle. L'application de ces tensions crée, à travers l'étroite couche d'oxyde 105, une forte tension ayant pour résultat la migration d'électrons vers la grille flottante 102 par effet tunnel. Ces électrons sont alors piégés dans la grille flottante 102.

A l'inverse, pour effacer une cellule mémoire, on applique à la ligne de bit une tension fortement positive et à la ligne de mot une tension nulle. La migration des électrons se fait alors dans le sens inverse et la grille flottante 102 se décharge.

Lors du transfert d'électrons entre la grille flottante 102 et la région drain 104, il est indispensable que la variation du champ électrique créé entre ces deux zones ne soit pas trop brutale afin de ne pas fragiliser voire détériorer la couche d'oxyde 105.

Par conséquent, on emploie un circuit de génération de rampe permettant d'augmenter de façon linéaire la tension appliquée sur la grille 101 ou sur la région drain 104 de la cellule mémoire.

Le document US A 4 996 571 décrit un procédé de programmation ou d'effacement d'une cellule mémoire consistant à produire une tension de programmation, Vpp, représentée à la figure 1b. Le signal en tension appliquée sur le drain ou la grille de commande de la cellule mémoire comporte trois phases:
- une polarisation de départ à la tension d'alimentation Vcc de la mémoire constituant un premier plateau 111 en tension.
- une rampe de tension constituée d'une phase ascendante 112 pendant laquelle la tension grimpe de façon linéaire jusqu'à une haute tension et d'un plateau 113 en tension pendant lequel s'effectue la fin de la charge (respectivement décharge) de la grille flottante 102 lors de la programmation (respectivement effacement) de la cellule mémoire. La pente de la phase ascendante 112 de la rampe est choisie de manière à ce que la variation du champ électrique entre le drain 104 et la grille flottante 102 ne soit pas trop rapide et de manière à limiter le flux d'électrons entre ces deux régions.
- une chute de tension 114 pendant laquelle la tension appliquée à la région drain 104 ou à la grille de commande 101 du transistor de la cellule mémoire revient à la valeur de la tension d'alimentation Vcc de la mémoire.

Le temps de programmation et d'effacement d'une cellule mémoire est alors principalement pénalisé par la durée de la phase ascendante de la tension de programmation ou d'effacement correspondante. En effet, la tension grimpe de façon linéaire pendant cette phase et le coefficient directeur de cette pente est choisi de manière à ce que la variation de champ électrique dans la cellule ne soit pas trop brutale.

Ce document divulgue également un diagramme temporel de tension de programmation dans lequel la tension augmente de façon exponentielle pendant la phase ascendante. La pente est alors très abrupte au début de cette phase puis décroit progressivement. Cette pente très élevée en début de phase ascendante ne va pas endommager la cellule sur laquelle est appliquée cette tension car il n'y a pas de transfert de charges élecriques en début de phase. La décroissance de la tension étant progressive, la durée de la phase ascendante est approximativement identique à celle de la figure 1b.

Le but de l'invention est de réduire encore le temps de programmation ou d'effacement d'une cellule mémoire sans nuire à la qualité de la cellule.

Pour se faire, on propose alors selon l'invention de diminuer la durée de la phase ascendante en divisant la phase ascendante en deux parties consécutives:
- une première partie pendant laquelle il n'y a pas de transfert de charges; le coefficient directeur de la pente correspondante peut alors être très élevé sans risque de fragiliser la cellule;
- une seconde partie pendant laquelle s'effectue le transfert de charges; le coefficient directeur de la pente correspondante est alors proche de celui de la phase ascendante de la figure 1b.

L'invention a donc pour objet un procédé de programmation ou d'effacement d'une cellule mémoire d'une mémoire non volatile comportant des éléments de mémorisation réalisés à partir de transistors à grille flottante et alimentée par une tension d'alimentation, comprenant les étapes suivantes :
- on produit une tension de programmation comportant un décalage de tension égal en valeur à une tension de référence, suivi d'une rampe de tension comportant une phase ascendante suivie éventuellement d'un plateau en tension, cette rampe de tension étant décalée en tension de la valeur de la tension de référence et étant suivie à son tour, d'une chute de tension,
- on applique cette tension de programmation à la cellule de la mémoire,
caractérisé en ce que
- on divise la phase ascendante de la rampe de tension en deux parties consécutives, une première partie pendant laquelle la tension s'élève jusqu'à une valeur intermédiaire, et une deuxième partie pendant laquelle la tension s'élève depuis cette tension intermédiaire jusqu'à la valeur de plateau, ladite tension intermédiaire étant inférieure à la valeur d'une tension dite tunnel de la cellule mémoire mais supérieure à la tension d'alimentation, la tension dite tunnel étant la tension minimale pour qu'il y ait un transfert d'électrons, à travers une couche d'oxyde, entre le drain et la grille flottante d'un transistor représentant la cellule mémoire,
- et en ce qu'on rend la pente de la première partie de la phase ascendante de la rampe supérieure à la pente de la deuxième partie.

En outre, l'invention concerne également un circuit de programmation ou d'effacement d'une cellule mémoire d'une mémoire comprenant
- un circuit de génération de rampe pour produire une rampe de tension,
- un circuit de génération d'une tension de programmation en cascade avec le circuit de génération de rampe pour obtenir une tension de programmation, la tension de programmation comportant un décalage de tension égal en valeur à une tension de référence, suivi d'une rampe de tension comportant une phase ascendante suivie éventuellement d'un plateau en tension, cette rampe de tension étant décalée en tension de la valeur de la tension de référence et étant suivie à son tour, d'une chute de tension,
- un circuit de commande pour appliquer à une cellule mémoire la tension de programmation issue du circuit de génération de tension de programmation,
caractérisé en ce que le circuit de génération de rampe comporte un circuit pour augmenter la pente de la rampe pendant une première partie de la phase ascendante de la rampe par rapport à la pente de la rampe pendant une deuxième partie consécutive de cette phase ascendante.

Les particularités de l'invention apparaîtront clairement dans la decription suivante faite en regard des figures annexées qui représentent :
- la figure 1a, un schéma en coupe d'un transistor à grille flottante;
- la figure 1b, un diagramme temporel connu de la tension de programmation (ou d'effacement) appliquée à une cellule mémoire;
- la figure 2, un diagramme temporel de la tension de programmation appliquée à une cellule mémoire selon l'invention;
- la figure 3a, un schéma fonctionnel du circuit de programmation ou d'effacement d'une cellule mémoire selon l'invention;
- la figure 3b, un schéma électronique du circuit de programmation ou d'effacement d'une cellule mémoire selon l'invention;
- la figure 3c, un diagramme temporel des signaux intervenant dans le fonctionnement du circuit de l'invention.

Les figures 1a et 1b, correspondant à un état de la technique, ont été précédemment décrites.

La figure 2 représente, selon l'invention, un diagramme temporel de la tension de programmation ou d'effacement, Vpp, appliquée sur la grille de commande 101 (respectivement sur le drain 104) pour programmer (respectivement effacer) la cellule mémoire. On cherche à réduire au maximum la durée de la période de ce signal.

Pour cela, la phase ascendante de la rampe de tension est divisée en deux parties consécutives, une première partie pendant laquelle la tension s'élève jusqu'à une valeur intermédiaire inférieure à la valeur de la tension tunnel de la cellule mémoire, et une deuxième partie pendant laquelle la tension s'élève depuis cette tension intermédiaire jusqu'à une valeur de plateau. Pour réduire la durée de la phase ascendante, on rend la pente de la première partie de la phase ascendante de la rampe supérieure à la pente de la deuxième partie. En variante, on remplace la première partie de la phase ascendante par un décalage brutal en tension, éventuellement combinée avec le décalage de tension égal à la tension de référence, qui dans ce cas aura même une durée nulle.

Dans le cas préféré, le signal de la tension de programmation, Vpp, appliquée sur la cellule mémoire en fonction du temps, représenté à la figure 2, se décompose de la manière suivante :
- un premier plateau en tension 201 pendant lequel la tension Vpp est égale à une tension de référence, par exemple, la tension d'alimentation Vcc.
- une première partie 202 de la phase ascendante pendant laquelle la tension Vpp atteint de façon linéaire une tension intermédiaire Vint.
- une deuxième partie 203 de la phase ascendante pendant laquelle la tension Vpp s'élève avec une pente plus faible depuis la tension intermédiaire Vint jusqu'à une valeur de tension maximale Vmax.
- un deuxième plateau en tension 204 pendant lequel la tension Vpp est égale à la tension maximale Vmax.
- une chute de tension 205 ramenant la tension Vpp à la tension d'alimentation Vcc.

On choisit la valeur intermédiaire de tension Vint de manière à ce qu'elle soit légèrement inférieure à la tension tunnel. On rappelle que la tension tunnel est la tension minimale nécessaire pour qu'une charge transite par effet tunnel à travers la couche d'oxyde 105, entre la grille flottante et la région drain d'un transistor. Typiquement, la valeur de la tension tunnel est de l'ordre de 10 volts.

Pendant la période 202, il n'y a pas ou très peu de transfert d'électrons entre la grille flottante 102 et la région drain 104 car la tension de programmation Vpp appliquée à la cellule mémoire est inférieure à la tension tunnel. De ce fait, une variation rapide du champ électrique entre la grille flottante 102 et la région drain 104, qui tend à accélérer le flux d'électrons dans la couche mince d'oxyde 105, n'est pas néfaste à la cellule mémoire pendant cette période. C'est pourquoi, pendant cette première partie 202, on rend la pente du signal de tension très abrupte pour minimiser la durée de la montée en tension.

Pendant la deuxième partie 203 de la phase ascendante, la tension aux bornes de la zone d'oxyde 105 est proche ou supérieure à la tension tunnel. Par conséquent, on limite la pente du signal de la tension Vpp pour que la variation du champ électrique dans la zone d'oxyde 105 ne soit pas trop rapide. Cette pente est fixée de manière à ne pas endommager la couche mince d'oxyde 105 par un flux d'électrons trop important. On retrouve alors une valeur de pente proche de celle du procédé connu.

Ensuite, le plateau 204 et la chute de tension 205 sont respectivement identiques au plateau 113 et la décharge 114.

Le procédé de l'invention permet d'obtenir un temps de programmation d'une cellule mémoire de l'ordre de 700 µs. Typiquement, ce temps est de l'ordre de 1 ms avec les procédés classiques. Le tracé en tirets sur la figure 2 rappelle cette amélioration.

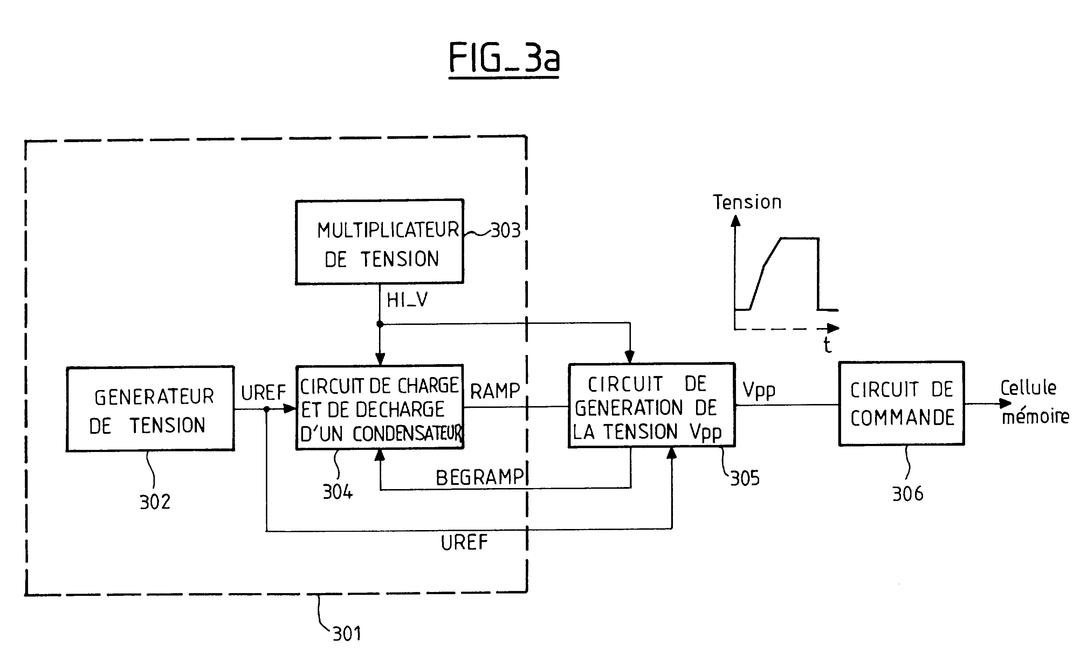

Pour produire la tension de programmation Vpp (figure 2), on réalise, par exemple, le circuit décrit à la figure 3a représentant un schéma fonctionnel du circuit de programmation ou d'effacement d'une cellule mémoire.

Ce circuit comporte ici:
- un circuit 301 de génération de rampe pour produire une rampe de tension,
- un circuit 305 de génération d'une tension de programmation en cascade avec le circuit 301 de génération de rampe pour obtenir la tension de programmation Vpp décrite à la figure 2,
- un circuit 306 de commande pour appliquer à une cellule mémoire la tension de programmation issue du circuit 305.

Le circuit 301 de génération de rampe comprend:
- un générateur de tension 302 stable en température,
- un multiplicateur de tension 303,
- un circuit 304 de charge et de décharge d'un condensateur.

Le générateur de tension 302 et le multiplicateur de tension 303 alimentent tous deux le circuit 304 de charge et de décharge d'un condensateur et le circuit 305 de génération de la tension Vpp, respectivement avec une tension UREF et une tension HI_V.

Le multiplicateur 303 de tension est par exemple, une pompe de charge. Sa fonction est de produire des hautes tensions, par exemple, de l'ordre de 15 à 20 volts.

La valeur de la tension UREF est, quant à elle, de l'ordre de 1 à 2 volts.

Par ailleurs, le circuit 305 de génération de tension de programmation alimenté lui aussi par le générateur de tension 302 et par le multiplicateur 303 de tension, reçoit une rampe de tension RAMP issu du circuit 304 de charge et de décharge d'un condensateur.

De son côté, le circuit 305 transmet un signal BEGRAMP au circuit 304 de charge et décharge d'un condensateur. L'état du signal BEGRAMP détermine la valeur de la pente du signal RAMP.

A partir du signal RAMP émis par le circuit 301, le circuit 305 produit une tension de programmation Vpp conforme au signal de tension représentée à la figure 2. Cette tension Vpp est ensuite appliquée par l'intermédiaire du circuit 306, soit sur la ligne de mot de la cellule à modifier, soit sur sa ligne de bit suivant le mode (programmation ou effacement) voulu.

Préalablement à la partie 202 de la phase ascendante, le circuit 305 modifie l'état du signal BEGRAMP et le transmet au circuit 301 afin de moduler la valeur de la pente du signal RAMP. La variation de la valeur de la pente de la rampe est obtenue par la charge plus ou moins rapide d'un condensateur. Le plateau 204 est, quant à lui, obtenu par décharge de ce même condensateur.

Pendant la partie 202 de la phase ascendante, le du condensateur se charge avec un courant important. Le condensateur se charge très rapidement.

Pendant la partie 203 de la phase ascendante, le condensateur se charge toujours mais avec un courant plus faible. Il en résulte que la pente du signal RAMP est plus faible que précédemment.

La tension de la rampe varie deux fois linéairement pendant les parties 202 et 203 de la phase ascendante car le condensateur se charge avec des courants constants pendant ces deux périodes.

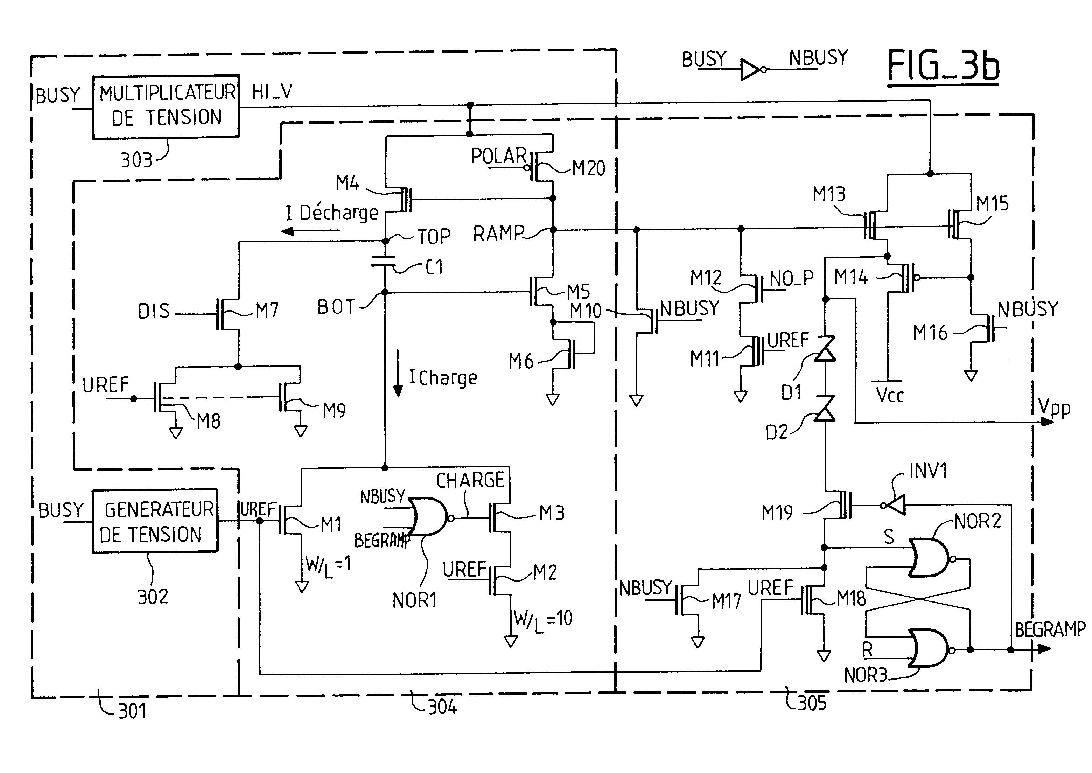

Une réalisation physique possible des circuits 301 et 305 est proposée à la figure 3b.

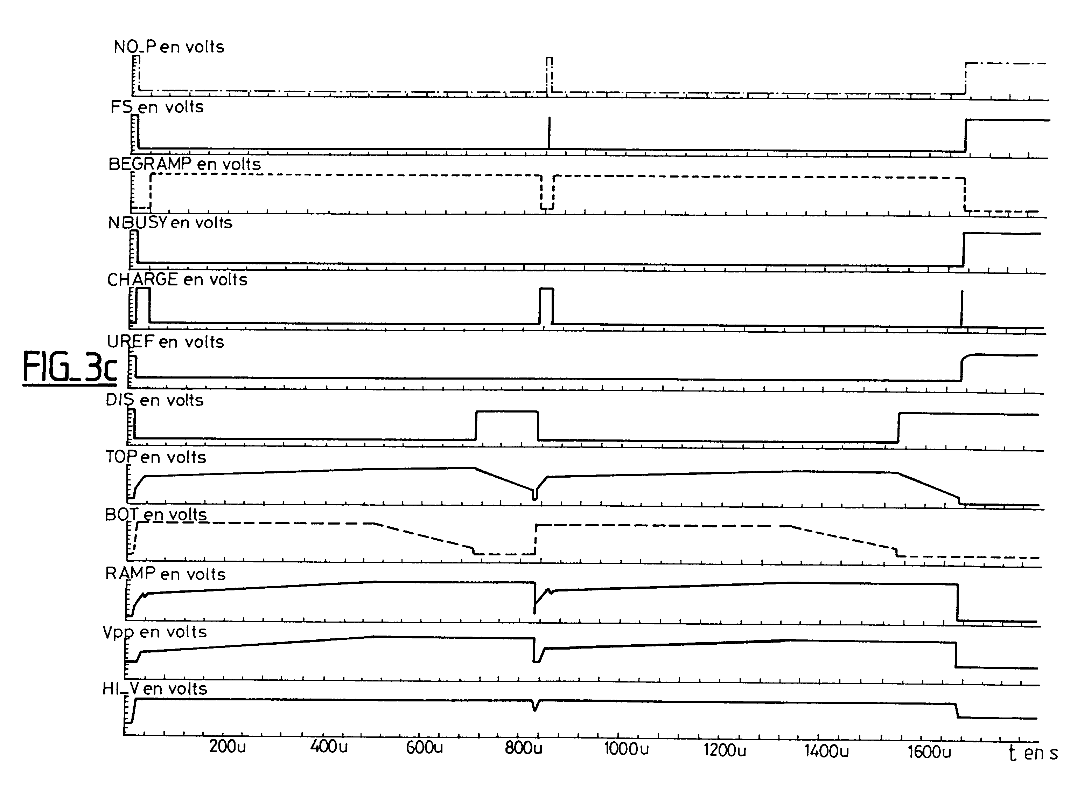

La forme de l'ensemble des signaux utilisés pour la mise en oeuvre du circuit est décrite sur la figure 3c. Pour une meilleure compréhension du fonctionnement du circuit, nous désignerons sur le schéma électronique (figure 3b) les connexions du circuit par le signal qu'elles véhiculent.

Le multiplicateur de tension 303 fournit la tension HI_V au drain d'un transistor natif M4 du circuit 304 et à la source d'un transistor M20 de ce même circuit 304. Un transistor natif est un transistor n'ayant pas reçu d'implantation complémentaire dans son canal de conduction. Sa tension de seuil de conduction est de l'ordre de 0.2 volts.

Le transistor M20 reçoit sur sa grille un signal POLAR. Le signal POLAR est une tension de polarisation du transistor M20. Dans un exemple, le signal POLAR vaut 14 volts lorsque la tension HI_V vaut 15 volts.

La grille du transistor M4 est reliée au drain du transistor M20 et sa source est reliée à une première borne, appelée borne supérieure, d'un condensateur C1. La tension présente à cette borne supérieure est appelée TOP. Une deuxième borne, appelée borne inférieure, du condensateur C1 est connectée à la grille d'un transistor M5. La tension présente à cette borne est appelée BOT.

Par ailleurs, le drain du transistor M5 est relié à la grille du transistor natif M4 et délivre le signal RAMP, et sa source est reliée à la grille et au drain d'un transistor M6. La source du transistor M6 est reliée à la masse. Dans ce circuit, le transistor M6 est utilisé comme résistance. L'ensemble constitué des transistors M4, M5 et M6 représente un circuit de régulation du courant de charge du condensateur C1.

Le générateur de tension 302 choisi stable en température, alimente la grille de deux transistors M1 et M2 du circuit 304, avec la tension UREF. La source des transistors M1 et M2 est reliée à la masse. Le drain du transistor M2 est reliée à la source d'un transistor M3. Le transistor M3 reçoit sur sa grille un signal CHARGE issu d'une porte NON OU appelé NOR1 recevant sur ses entrées les signaux NBUSY et BEGRAMP. Le drain des transistors M1 et M3 est reliée à la borne inférieure du condensateur C1. La partie du circuit contenant les transistors M1, M2, M3 et la porte NOR1 constitue le circuit de charge du circuit 301 de génération de rampe. On désigne par courant de charge Icharge le courant total traversant les transistors M1 et M2.

Le circuit 301 comprend également un transistor M7 dont le drain est relié à la borne supérieure du condensateur C1. La source du transistor M7 est reliée aux drains de plusieurs transistors branchés en parallèle, représentés par deux transistors M8 et M9. Le générateur de tension 302 alimente les grilles des transistors M8 et M9 avec la tension UREF. La source des transistors M8 et M9 est reliée à la masse. Le transistor M7 est commandé par un signal DIS alimentant sa grille. On désigne par courant de décharge, Idécharge, le courant traversant le transistor M7. Le nombre de transistors en parallèle avec les transistors M8 et M9 est fonction du courant de décharge voulu.

Le signal RAMP issu du circuit 301 est alors traité par le circuit 305 pour produire la tension de programmation Vpp. Le signal RAMP alimente les grilles de deux transistors natifs, M13 et M15. Le multiplicateur de tension 303 délivre la tension HI_V sur les drains de ces deux transistors. Les sources des transistors natifs M13 et M15 sont respectivement reliées à la source du transistor natif M14 et au drain du transistor M16. On notera que tous les transistors utilisés dans ce circuit sont de type N excepté les transistors M14 et M20. Le drain du transistor natif M14 est reliée à une tension d'alimentation égale à la tension d'alimentation Vcc d'une mémoire. La grille du transistor M14 est connectée au drain du transistor M16. Enfin, la source du transistor M16 est reliée à la masse et sa grille reçoit le signal NBUSY. Le circuit constitué de ces quatre transistors (M13 à M16) est un circuit de polarisation imposant la tension d'alimentation Vcc comme tension de référence du signal de tension Vpp.

Le signal de tension Vpp est disponible à la source du transistor M13 et est soumis à un détecteur de niveau. Si la tension Vpp est supérieure à la tension intermédiaire Vint, le signal BEGRAMP issu du détecteur de tension est à 1. Dans le cas contraire, il est à 0.

Ce détecteur de niveau comprend une bascule RS, trois transistors M17, M18 et M19, et deux diodes zener, D1 et D2.

La bascule RS est constitué de deux portes NON OU, NOR2 et NOR3. Cette bascule possède deux entrées R et S. Elle reçoit sur l'entrée R un signal FS et délivre en sortie le signal BEGRAMP. Le signal BEGRAMP est transmis à l'une des entrées de la porte NOR1 du circuit de charge du circuit 301.

Les transistors M17 et M18 connectés en parallèle, recevant respectivement sur leurs grilles les signaux NBUSY et UREF, ont leurs sources reliées à la masse et leurs drains reliées à l'entrée S de la bascule RS.

Le transistor natif M19 en série avec les deux transistors M17 et M18 a sa source reliée à l'entrée S de la bascule. Le drain du transistor natif M19 est connectée à la cathode d'une première diode zener D1 en série avec une deuxième diode zener D2 dont l'anode est reliée à la source du transistor natif M14. De plus, le signal BEGRAMP est ramené sur la grille du transistor natif M19 après avoir été modifié par un inverseur INV1.

Enfin, le circuit comprend également le transistor M10 connecté entre la sortie RAMP du circuit 301 et la masse, et commandé par le signal NBUSY. Ce transistor M10 permet d'annuler le signal RAMP quand NBUSY passe à 1. Les transistors M11 et M12 branchés en série entre la sortie RAMP du circuit 301 et la masse, et commandés respectivement par les signaux UREF et NO_P, permettent de provoquer le retour 205 à la tension d'alimentation constituant la tension de polarisation du circuit 305.

A l'aide des chronogrammes des signaux utilisés dans le circuit et représentés à la figure 3c, nous allons étudier le fonctionnement du circuit. Dans la réalisation choisie, la valeur de la tension intermédiaire Vint est fixée à 10 volts. Le fonctionnement sera expliqué au travers des 5 phases de la tension de programmation Vpp (figure 2).

Pour la mise en marche du dispositif, le signal BUSY passe à 1. Le générateur de tension stable 302 et le multiplicateur de tension 303, commandés en entrée par le signal BUSY, délivrent respectivement une tension UREF stable en température et une haute tension HI_V.

Pendant le plateau 201, la tension Vpp est égale à la tension de référence fournie par le sous-circuit constitué des transistors M13 à M16. Dans notre exemple, cette tension de référence est égale à la tension d'alimentation Vcc. Pendant cette phase, le signal NO_P passe à 0 et le transistor M11 se bloque. La tension RAMP peut alors commencer à monter. Tant que la tension RAMP est inférieure à la tension de référence, la tension Vpp reste égale à cette tension de référence.

Pendant cette phase, le signal FS passe à 1 par l'intermédiaire de circuits annexes. Le changement d'état de l'entrée R de la bascule RS implique le passage du signal BEGRAMP à 0. Le signal CHARGE passe alors à 1. Le signal FS repasse ensuite très rapidement à 1 mais cela ne modifie en rien l'état du signal BEGRAMP.

Les transistors M1 et M2 alimentés par la tension UREF sont passants. La tension UREF appliquée sur la grille des transistors M1 et M2 est constante et stable. Les transistors M1 et M2 se comportent alors comme des sources de courant constant. Le transistor M2 impose un courant très important car il possède une largeur de canal de conduction très importante. Dans l'exemple de la figure 3.b, le transistor M2 est obtenu avec la mise en parallèle de 10 transistors équivalents au transistor M1.

Le condensateur C1 se charge alors rapidement avec un courant de charge Icharge important et la valeur de la tension RAMP atteint rapidement la tension de référence. La partie 202 de la phase ascendante débute alors.

Pendant la partie 202 de la phase ascendante, le condensateur poursuit sa charge rapide. A mesure que le condensateur se charge, les potentiels TOP et BOT grimpent. Comme le potentiel TOP augmente, la tension RAMP augmente par couplage capacitif entre la grille et la source du transistor M4.

Un circuit de régulation du courant, constitué des transistors M4, M5 et M6, permet de limiter les variations du courant de charge Icharge. Lorsque le courant de charge Icharge diminue, la tension en BOT diminue. Le transistor M5 se rapproche de l'état bloqué; il devient plus résistant. La valeur de la tension du signal RAMP a tendance à augmenter et se rapproche de la tension HI_V. On rappelle que le transistor M6 se comporte comme une résistance. Le transistor M4 devient alors moins résistant et le courant Icharge augmente.

La tension RAMP augmente de cette manière jusqu'à la tension Vint. La tension Vpp suit alors la tension RAMP. Lorsque la tension Vpp atteint la tension Vint, le détecteur de niveau détecte cette valeur. Les diodes zener D1 et D2 deviennent passantes. L'entrée S de la bascule RS passe à 1 et le signal de sortie de la bascule, BEGRAMP, passe à 1. Le transistor natif M18 permet de limiter le courant traversant les diodes zener.

Le signal CHARGE passe alors à 0. Le courant de charge Icharge du condensateur C1 se limite alors au courant imposé par le transistor M1. C'est le début de la partie 203 de la phase ascendante.

Pendant la phase 203, le condensateur se charge avec un courant Icharge beaucoup plus faible que précédemment. Le potentiel TOP ainsi que le signal RAMP grimpent plus lentement.

On a vu que le signal BEGRAMP est passé à 1. Ce signal est alors inversé par l'inverseur INV1 et ramené sur la grille du transistor M19. Le transistor M19 se bloque et l'entrée S repasse à 0. Le signal BEGRAMP en sortie est maintenu à 1. Par ce moyen, le détecteur de niveau est désactivé pour éviter toute consommation inutile.

Il arrive un moment où le potentiel TOP atteint un maximum. Le condensateur C1 continuant à se charger, le potentiel BOT s'abaisse. Au dessous d'un seuil proche de la tension de seuil Vt du transistor M5, ce potentiel déclenche le signal DIS qui passe alors à 1. Le signal DIS active le circuit de décharge du condensateur C1. Le transistor M5 se bloque. C'est le début de la partie 204.

Pendant la phase 204, le signal DIS au niveau haut rend passant le transistor M7. Le condensateur C1 se décharge par l'intermédiaire de l'ensemble des transistors en parallèle représentés par M8 et M9. Le nombre de transistors en parallèle est choisi afin d'obtenir une décharge plus ou moins rapide du condensateur C1. Le potentiel en TOP s'abaisse à mesure que le condensateur C1 se décharge.

Le signal RAMP est maintenu à sa valeur maximale obtenue en fin de charge du condensateur C1 car le transistor M5 est bloqué. Le signal de tension Vpp présente alors un plateau 204 en tension.

Le potentiel TOP chute au fur et à mesure de la décharge et fait passer le signal DIS à 0 lorsqu'il devient inférieur à un potentiel seuil. A ce moment précis, le signal NO_P passe à 1. C'est le début de la phase 205.

Pendant cette chute de tension 205, le transistor M11 est rendu passant. La tension RAMP diminue très rapidement pour atteindre une valeur inférieure à la tension de référence. En ce qui concerne la tension Vpp, elle chute jusqu'à la tension de référence. Le signal NO_P repasse à 1 et on recommence la phase 201.

Différentes évolutions peuvent être apportées à ce schéma. Par exemple, on peut vouloir un signal de rampe RAMP différent pour le cycle de programmation et pour le cycle d'effacement d'une cellule mémoire. Dans le schéma de la figure 3a, on peut par exemple rendre passant les 10 transistors en parallèle de M2 pendant le cycle de programmation et n'en activer que la moitié pendant le cycle d'effacement. La charge du condensateur C1 sera alors plus lente lors du cycle d'effacement d'une cellule mémoire. La durée du cycle d'effacement d'une cellule mémoire sera alors plus longue que celle du cycle de programmation.

## Revendications

1. Procédé de programmation ou d'effacement d'une cellule mémoire d'une mémoire non volatile comportant des éléments de mémorisation réalisés à partir de transistors à grille flottante et alimentée par une tension d'alimentation (Vcc), comprenant les étapes suivantes :
- on produit une tension de programmation (Vpp) comportant un décalage (201) de tension égal en valeur à une tension de référence, suivi d'une rampe de tension (RAMP) comportant une phase ascendante (202 et 203) suivie éventuellement d'un plateau en tension (204), cette rampe de tension étant décalée en tension de la valeur de la tension de référence et étant suivie à son tour, d'une chute de tension (205),
- on applique cette tension de programmation (Vpp) à la cellule de la mémoire,
caractérisé en ce que
- on divise la phase ascendante de la rampe de tension en deux parties consécutives, une première partie (202) pendant laquelle la tension s'élève jusqu'à une valeur intermédiaire (Vint), et une deuxième partie (203) pendant laquelle la tension s'élève depuis cette tension intermédiaire (Vint) jusqu'à la valeur de plateau, ladite tension intermédiaire (Vint) étant inférieure à la valeur d'une tension dite tunnel de la cellule mémoire mais supérieure à la tension d'alimentation (Vcc), la tension dite tunnel étant la tension minimale pour qu'il y ait un transfert d'électrons, à travers une couche d'oxyde, entre le drain et la grille flottante d'un transistor représentant la cellule mémoire,
- et en ce qu'on rend la pente de la première partie (202) de la phase ascendante de la rampe supérieure à la pente de la deuxième partie (203).

2. Procédé selon la revendication 1, caractérisé en ce que
- on produit une première et une deuxième rampe différentes respectivement pour le cycle d'effacement et le cycle de programmation de la cellule mémoire.

3. Procédé selon la revendication 1 ou la revendication 2, caractérisé en ce que la durée de la rampe de programmation est différente de la durée de la rampe d'effacement.

4. Circuit de programmation ou d'effacement d'une cellule mémoire d'une mémoire comprenant
- un circuit de génération de rampe (301) pour produire une rampe de tension (RAMP),
- un circuit de génération d'une tension de programmation (305) en cascade avec le circuit de génération de rampe (301) pour obtenir une tension de programmation (Vpp), la tension de programmation (Vpp) comportant un décalage (201) de tension égal en valeur à une tension de référence, suivi d'une rampe de tension (RAMP) comportant une phase ascendante (202 et 203) suivie éventuellement d'un plateau en tension (204), cette rampe de tension étant décalée en tension de la valeur de la tension de référence et étant suivie à son tour, d'une chute de tension (205),
- un circuit de commande (306) pour appliquer à une cellule mémoire la tension de programmation (Vpp) issue du circuit de génération de tension de programmation (305),
caractérisé en ce que le circuit de génération de rampe (301) comporte un circuit (304) pour augmenter la pente de la rampe pendant une première partie (202) de la phase ascendante de la rampe par rapport à la pente de la rampe pendant une deuxième partie (203) consécutive de cette phase ascendante.

5. Circuit selon la revendication 4, caractérisé en ce que le circuit de génération de rampe (301) comporte un ensemble (M2) de transistors identiques en parallèle montés dans un circuit de charge et de décharge (304) à courant constant d'un condensateur, et un circuit de commutation pour que ces transistors soient passants ou non suivant la pente de la rampe.

6. Circuit selon la revendication 4 ou la revendication 5, comprenant un circuit de charge et de décharge (304) d'un condensateur comportant un premier (M4) et un deuxième (M5) transistor, la grille et le drain du deuxième transistor (M5) étant respectivement connectés à une première borne d'un condensateur (C1) et à la grille du premier transistor (M4), la source du premier transistor (M4) étant reliée à une deuxième borne du condensateur (C1) caractérisé en ce que le drain du deuxième transistor (M5) délivre la tension de rampe (RAMP).

7. Circuit selon la revendication 4, comportant un circuit de génération d'une tension de programmation (305) caractérisé en ce qu'il comporte un détecteur de niveau qui, lorsque la tension de programmation (Vpp) a atteint une valeur intermédiaire (Vint) inférieure à une tension tunnel, transmet un signal (BEGRAMP) au circuit de génération de rampe (301) pour diminuer la pente de la deuxième partie (203) de la phase ascendante de la rampe.

## Patentansprüche

1. Verfahren zum Programmieren oder Löschen einer Speicherzelle eines nichtflüchtigen Speichers mit Speicherelementen in Form von Transistoren mit floatendem Gate, versorgt mit einer Versorgungsspannung (Vcc), mit den folgenden Schritten:
- man erzeugt eine Programmierspannung (Vpp) mit einer Spannungsverschiebung (201), die gleich dem Wert einer Referenzspannung ist, gefolgt von einer Spannungsrampe (RAMP) mit ansteigender Phase (202 und 203), gefolgt eventuell von einem Spannungsplateau (204), wobei diese Spannungsrampe in der Spannung gegenüber dem Referenzspannungswert verschoben ist, und der wiederum ein Abfall der Spannung (205) folgt,
- man legt diese Programmierspannung (Vpp) an die Speicherzelle an,
dadurch gekennzeichnet, daß
- man die ansteigende Phase der Spannungsrampe in zwei aufeinanderfolgende Teile unterteilt, einen ersten Teil (202), während dessen die Spannung steigt bis auf einen Zwischenwert (Vint), und einen zweiten Teil (203), während dessen die Spannung von diesem Zwischenwert (Vint) auf den Plateauwert steigt, wobei die Zwischenspannung (Vint) kleiner als der Wert einer sogenannten Tunnelspannung der Speicherzelle aber größer als die Versorgungsspannung (Vcc) ist, wobei die sogenannte Tunnelspannung die minimale Spannung für einen Elektronentransfer durch eine Oxidschicht zwischen dem Drain und dem floatenden Gate eines Transistors ist, der die Speicherzelle darstellt,
- und dadurch, daß man die Neigung des ersten Teils (202) der ansteigenden Phase der Rampe größer als die Neigung des zweiten Teils (203) macht.

2. Verfahren nach Anspruch 1, dadurch gekennzeichnet, daß
- man eine erste und eine zweite unterschiedliche Rampe jeweils für den Löschzyklus und den Programmierzyklus der Speicherzelle erzeugt.

3. Verfahren nach Anspruch 1 oder 2, dadurch gekennzeichnet, daß die Dauer der Programmierrampe sich von der Dauer der Löschrampe unterscheidet.

4. Schaltkreis zum Programmieren oder Löschen einer Speicherzelle eines Speichers, umfassend:
- einen Rampengeneratorschaltkreis (301) zum Erzeugen einer Spannungsrampe (RAMP),
- einen Generatorschaltkreis für eine Programmierspannung (305) in Kaskade mit dem Rampengeneratorschaltkreis (301), um eine Programmierspannung (Vpp) zu erzeugen, wobei die Programmierspannung (Vpp) eine Verschiebung (201) der Spannung gleich dem Wert einer Referenzspannung umfaßt, gefolgt von einer Spannungsrampe (RAMP) mit einer ansteigenden Phase (202 und 203), eventuell gefolgt von einem Spannungsplateau (204), wobei diese Spannungsrampe in der Spannung um den Referenzspannungswert verschoben ist und ihr wiederum ein Abfall der Spannung (205) folgt,
- einen Steuerschaltkreis (306) zum Anlegen der Programmierspannung (Vpp) an eine Speicherzelle, die durch den Generatorschaltkreis für die Programmierspannung (305) ausgegeben wurde,
dadurch gekennzeichnet, daß der Rampengeneratorschaltkreis (301) einen Schaltkreis (304) zum Anheben der Neigung der Rampe während eines ersten Teils (202) der ansteigenden Phase der Rampe in bezug auf die Neigung der Rampe während eines folgenden zweiten Teils (203) dieser ansteigenden Phase umfaßt.

5. Schaltkreis nach Anspruch 4, dadurch gekennzeichnet, daß der Rampengeneratorschaltkreis (301) eine Gruppe (M2) von identischen Transistoren , die in einem Lade- und Entladeschaltkreis (304) für konstanten Strom eines Kondensators parallel geschaltet sind, und einen Kommutatorschaltkreis umfaßt, damit diese Transistoren leitend oder nichtleitend je nach Neigung der Rampe sind.

6. Schaltkreis nach Anspruch 4 oder 5, der einen Lade- und Entlade-Schaltkreis (304) eines Kondensators umfaßt, der einen ersten (M4) und einen zweiten (M5) Transistor umfaßt, wobei Gate und Drain des zweiten Transistors (M5) jeweils mit einem ersten Anschluß eines Kondensators (C1) und dem Gate des ersten Transistors (M4) verbunden sind und die Source des ersten Transistors (M4) mit einem zweiten Anschluß des Kondensators (C1) verbunden sind, dadurch gekennzeichnet, daß der Drain des zweiten Transistors (M5) die Rampenspannung (RAMP) ausgibt.

7. Schaltkreis nach Anspruch 4, der einen Generatorschaltkreis für eine Programmierspannung (305) umfaßt, dadurch gekennzeichnet, daß er einen Pegeldetektor umfaßt, der bei dem Erreichen eines Zwischenwertes (Vint) durch die Programmierspannung (Vpp), der kleiner als eine Tunnelspannung ist, ein Signal (BEGRAMP) an den Rampengeneratorschaltkreis (301) übermittelt, um die Neigung des zweiten Teils (203) der steigenden Phase der Rampe zu verringern.

## Claims

1. Method of programming or erasing a memory cell of a nonvolatile memory having storage elements produced from floating-gate transistors and powered by a supply voltage (Vcc), comprising the following steps:
- a programming voltage (Vpp) is produced, having a voltage offset (201) equal in value to a reference voltage, followed by a voltage ramp (RAMP) having a rising phase (202 and 203) possibly followed by a voltage plateau (204), this voltage ramp being offset in voltage by the value of the reference voltage and being followed in its turn by a voltage drop (205),
- this programming voltage (Vpp) is applied to the memory cell,
characterised in that
- the rising phase of the voltage ramp is divided into two consecutive parts, a first part (202) during which the voltage increases up to an intermediate value (Vint), and a second part (203) during which the voltage rises from this intermediate voltage (Vint) up to the plateau value, the said intermediate voltage (Vint) being less than the value of a so-called tunnel voltage of the memory cell but greater than the supply voltage (Vcc), the so-called tunnel voltage being the minimum voltage at which there is a transfer of electrons, to an oxide layer, between the drain and floating gate of a transistor representing the memory cell,
- and in that the slope of the first part (202) of the rising phase of the ramp is made greater than the slope of the second part (203).

2. Method according to Claim 1, characterised in that
- different first and second ramps are produced respectively for the erasure cycle and the programming cycle of the memory cell.

3. Method according to Claim 1 or Claim 2, characterised in that the duration of the programming ramp is different from the duration of the erasure ramp.

4. Circuit for programming or erasing a memory cell of a memory comprising
- a ramp generator circuit (301) for producing a voltage ramp (RAMP),
- a circuit for generating a programming voltage (305) in cascade with the ramp generator circuit (301) in order to obtain a programming voltage (Vpp), the programming voltage (Vpp) having a voltage offset (201) equal in value to a reference voltage, followed by a voltage ramp (RAMP) having a rising phase (202 and 203) possibly followed by a voltage plateau (204), this voltage ramp being offset in voltage by the value of the reference voltage and being followed in its turn by a voltage drop (205),
- a control circuit (306) for applying, to a memory cell, the programming voltage (Vpp) issuing from the programming voltage generating circuit (305),
characterised in that the ramp generator circuit (301) includes a circuit (304) for increasing the slope of the ramp during a first part (202) of the rising phase of the ramp compared with the slope of the ramp during a consecutive second part (203) of this rising phase.

5. Circuit according to Claim 4, characterised in that the ramp generator circuit (301) includes a set (M2) of identical transistors in parallel mounted in a circuit (304) for charging and discharging a capacitor at constant current, and a switching circuit so that these transistors will or will not be conducting depending on the slope of the ramp.

6. Circuit according to Claim 4 or Claim 5, comprising a circuit (304) for charging and discharging a capacitor including a first (M4) and a second (M5) transistor, the gate and drain of the second transistor (M5) being respectively connected to a first terminal of a capacitor (C1) and to the gate of the first transistor (M4), the source of the first transistor (M4) being connected to a second terminal of the capacitor (C1), characterised in that the drain of the second transistor (M5) delivers the ramp voltage (RAMP).

7. Circuit according to Claim 4, including a circuit for generator a programming voltage (305), characterised in that it includes a level detector which, when the programming voltage (Vpp) has reached an intermediate value (Vint) lower than a tunnel voltage, transmits a signal (BEGRAMP) to the ramp generator circuit (301) in order to reduce the slope of the second part (203) of the rising phase of the ramp.
